# EUROPÄISCHE PATENTANMELDUNG

(11) **EP 3 528 002 A1**
(43) Veröffentlichungstag der Anmeldung: **21.08.2019**
(21) Anmeldenummer: 18157647.1
(22) Anmeldetag: 20.02.2018
(51) Int. Cl.: G01R 33/483, G01R 33/561, G01R 33/48

(54) **VERFAHREN ZUR AUFNAHME EINES MAGNETRESONANZDATENSATZES, COMPUTERPROGRAMMPRODUKT, DATENTRÄGER SOWIE MAGNETRESONANZANLAGE**

(71) Anmelder: Siemens Healthcare GmbH, 91052 Erlangen (DE)
(72) Erfinder: Zeller, Mario, 91054 Erlangen (DE)

(57) **Zusammenfassung**

Die Erfindung betrifft ein Verfahren zur Aufnahme eines Magnetresonanzdatensatzes mit mehreren Spulen (9, 10, 11, 12), wobei die Messdaten (19, 20, 21) des Magnetresonanzdatensatzes Messsignale wenigstens zweier Bilddatensätze jeweils aus wenigstens zwei Schichten enthalten, mit den Schritten: Anregungsphase, Evolutionsphase, Auslesen eines ersten Echosignals (19) während ein erster Lesegradient (22) anliegt, Anlegen wenigstens eines Verschiebegradienten (32, 45, 50, 54) in Schichtauswahlrichtung, und Auslesen wenigstens eines weiteren Echosignals (21, 22) während ein weiterer Lesegradient (23, 24) anliegt, wobei der Verschiebegradient (32, 45, 50, 54) so positioniert ist, dass er eine Verschiebung wenigstens eines aus dem oder den weiteren Echosignalen (20, 21) erzeugten weiteren Bilddatensatzes gegenüber dem aus ersten Echosignalen (19) erzeugten ersten Bilddatensatz bewirkt. Die Erfindung betrifft ferner ein Computerprogrammprodukt, einen Datenträger und eine Magnetresonanzanlage.

## Beschreibung

Bei der Magnetresonanztomographie werden Bilddaten durch die Aufnahme räumlich kodierter Hochfrequenzsignale erhalten, wobei die Hochfrequenzsignale bspw. mittels einer Fouriertransformation zu prozessieren sind, damit sie als Bilddatensatz zu Verfügung stehen.

Die Magnetresonanztomographie ist zwar gegenüber CT und Röntgen dahingehend von Vorteil, dass sie keinerlei Röntgenstrahlung benötigt. Allerdings benötigte sie gerade in der Anfangszeit erhebliche Messzeiten im Bereich von 5 Minuten aufwärts für die Messung eines einzigen Bildes.

Der erste Schritt zur Beschleunigung bestand in der Beschleunigung der Grundmesssequenzen Spinecho und Gradientenecho. Bei Gradientenechos konnte eine Beschleunigung durch Verkleinerung des Auslenkwinkels und die dadurch mögliche Verkürzung der Repetitionszeit erreicht werden. Derartige Sequenzen sind unter dem Akronym FLASH (Fast Low Angle SHot) bekannt.

Bei einem EPI (Echo Planar Imaging) wird ein Gradientenechozug aufgenommen.

Zur Beschleunigung eines Spinechos wird ebenfalls ein Echozug aufgenommen. Dabei werden zur Refokussierung allerdings keine Gradienten sondern HF-Refokussierungsimpulse verwendet. Diese sind unter den Akronymen TSE (Turbo Spin Echo), FSE (Fast Spin Echo) oder RARE (Rapid Acquisition with Relaxation Enhancement) bekannt.

Durch diese Sequenzen kommen die Messzeiten eines Bilddatensatzes in den Bereich von Sekunden bis Teile einer Minute. Eine weitere Beschleunigung war dann notwendig um bspw. das Signal-Rausch-Verhältnis zu steigern, für 3D-Bilddatensätze und für funktionelle Bildgebung.

Diese wurde erreicht durch die sogenannte parallele Bildgebung. Dabei handelt es sich um einen Sammelbegriff für verschiedene Aufnahme- und insbesondere Auswertungsverfahren. Diese haben die Gemeinsamkeit, dass die Messdaten gleichzeitig mit mehreren Spulen aufgenommen werden. Eine Reduktion der Messzeit ergibt sich dadurch, dass nur noch ein Teil der k-Raum-Zeilen aufgenommen wird, dafür aber mit mehreren Spulen.

Die Daten jeder einzelnen Spule sind undersampelt, wodurch ein sogenanntes Aliasing-Artefakt entsteht. Zur Vermeidung der Einfaltungen gibt es mehrere Vorgehensweisen:
Bei GRAPPA (GeneRalized Autocalibrating Partially Parallel Acquisition) werden die fehlenden k-Raum-Zeilen im k-Raum rekonstruiert. Dabei wird aus mehreren gemessenen k-Raumzeilen eine k-Raum-Zeile bestimmt.

Bei SENSE (SENSitivity Encoding for fast MRI) werden dagegen die Bilddaten der einzelnen Spulen verwendet, um ein entfaltetes Bild zu ermitteln. Auch Sensitivitätskarten der Spulen werden berücksichtigt.

Die Entfaltung geht bei den beschriebenen Verfahren immer auf Sensitivitätsunterschiede der Messspulen zurück. Zur Verstärkung der Unterschiede gibt es bekannte Verfahren unter dem Akronym CAIPIRINHA (Controlled Aliasing In Parallel Imaging Results IN Higher Acceleration). Dabei handelt es sich also nicht um Rekonstrunstruktionsverfahren, sondern um Abwandlungen bekannter Messsequenzen.

Bei MS-CAIPIRINHA wird ein alternierender Dual-Band-Puls eingesetzt, um zwei Schichten anzuregen. 2D-CAIPIRINHA beruht darauf, Sensitivitätsvariationen bei dreidimensionaler Bildgebung zu verbessern.

Die durch die CAIPIRINHA-Verfahren erzeugten Sensitivitätsänderungen sind dann in den Sensitivitätsmatrizen zu berücksichtigen. Die Rekonstruktionsverfahren wie GRAPPA oder SENSE können ansonsten unverändert verwendet werden.

Die Methoden der parallelen Bildgebung können auch eingesetzt werden, um Messdaten für ein Dixon-Verfahren, nämlich 2-Punkt-Dixon oder 3-Punkt-Dixon, zu erhalten. Diese werden bekanntermaßen verwendet, um aus zwei oder drei Bilddatensätzen ein reines Wasser- und ein reines Fettbild zu berechnen.

Dabei werden Echos akquiriert, bei denen die Wasserprotonen und die Fettprotonen einmal "in phase", also in Phase bzw. gleichsinnig und ein- oder zweimal "opposed phase", also mit entgegengesetzter Phase, orientiert sind. Auch bei spinechobasierten Sequenzen wird dabei üblicherweise ein Gradientenechozug zur Erzeugung der zwei bzw. drei Echos der zwei bzw. drei Bilddatensätze verwendet. Bei diesem wechseln sich ein "opposed phase"-Echo, ein "in phase"-Echo und ggf. ein weiteres "opposed phase"-Echo ab.

Dieser Gradientenechozug kann auch in eine schnelle Spinechosequenz eingebaut sein. Dann wird nach jedem Refokussierungsimpuls ein derartiger Gradientenechozug erzeugt bzw. aufgenommen. Die k-Raum-Zeilen der Echos entsprechen dabei einander, auch die Schichtanordnung ist identisch. D.h. dass zu jedem Bild die identische Schicht oder Schichten derselben k-Raum-Zeilenposition in Phasenrichtung aufgenommen werden.

Bei der Verwendung mehrerer Spulen und insbesondere bei Verwendung von CAIPIRINHA-Verfahren zur Sensitivitätssteigerung kann es dabei zu Problemen während der Datenrekonstruktion kommen.

Es ist daher Aufgabe der vorliegenden Erfindung, ein Verfahren zur Aufnahme von Messdaten anzugeben, das eine spätere Separation von Wasser- und Fettprotonen erlaubt, das parallele Bildgebung und insbesondere CAIPIRINHA-Verfahren zulässt und bei dem die Rekonstruktion der zu erzeugenden Bilddaten verbessert ist.

Diese Aufgabe wird gelöst durch ein Verfahren zur Aufnahme eines Magnetresonanzdatensatzes mit mehreren Spulen, wobei die Messsignale des Magnetresonanzdatensatzes Messsignale wenigstens zweier Bilddatensätze jeweils aus wenigstens zwei Schichten enthalten, mit den Schritten:
a) Anregungsphase,
b) Evolutionsphase,
c) Detektionsphase mit:
   c1) Auslesen eines ersten Echosignals während ein erster Lesegradient anliegt,
   c2) Anlegen wenigstens eines Verschiebegradienten in Schichtauswahlrichtung, und
   c3) Auslesen wenigstens eines weiteren Echosignals während ein weiterer Lesegradient anliegt, wobei
   c4) der Verschiebegradient so positioniert ist, dass er eine Verschiebung wenigstens eines aus dem oder den weiteren Echosignalen erzeugten weiteren Bilddatensatzes gegenüber dem aus ersten Echosignalen erzeugten ersten Bilddatensatz bewirkt.

Als Kern der Erfindung wird dabei angesehen, bei einer Messsequenz in wenigstens einer Detektionsphase in Schichtrichtung wenigstens einen Verschiebegradienten anzulegen.

Ein Verfahren zur Aufnahme eines Magnetresonanzdatensatzes, auch Messsequenz genannt, besteht grundsätzlich aus drei Phasen: Anregungsphase, Evolutionsphase und Detektionsphase.

Während der Anregungsphase können Präparationsmodule eingesetzt werden. Sie schließt mit dem letzten HF-Impuls zur Anregung ab. Bei einem Spinecho besteht die Anregungsphase lediglich aus dem 90°-Impuls, bei einem FLASH aus dem HF-Impuls.

Bevorzugt weist die Anregungsphase das Anlegen eines Anregungsimpulses, insbesondere eines einzigen Anregungsimpulses, auf. Dieser kann eine 2D-Schicht, mehrere Schichten oder ein 3D-Volumen anregen.

Der Anregungsimpuls kann vorteilhafterweise als Mehrbandimpuls, insbesondere als Dualbandimpuls, ausgestaltet sein. Dann kann der Anregungsimpuls zwei bzw. mehrere Schichten gleichzeitig anregen. Vorzugsweise kann während des Anliegens des Anregungsimpulses gleichzeitig ein Schichtauswahlgradient angelegt sein. Dies ist unabhängig von der Pulsform möglich.

Die Schichten, die gleichzeitig akquiriert werden, liegen parallel, d.h. sie kreuzen sich nicht.

In der Evolutionsphase können sich bspw. wenigstens ein Schicht-Rephasiergradient und/oder wenigstens ein Phasenkodiergradientund/oder wenigstens ein Lesedephasiergradient und/oder wenigstens ein Refokussierungsimpuls, etc. finden.

In der Detektionsphase sind bei bildgebenden Sequenzen üblicherweise Lesegradienten angelegt, außerdem ist das Akquisitionsfenster offen.

In einer Sequenz können auf eine Anregungsphase auch mehrere Evolutions- und Detektionsphasen folgen, wie es z.B. beim FSE der Fall ist. Ansonsten werden die Phasen solange wiederholt, bis alle Messsignale aufgenommen sind.

Die Abfolge der Schritte gibt dabei auch die zeitliche Abfolge des Ablaufs vor. D.h. dass der Verschiebegradient erst nach dem Auslesen des ersten Echosignals angelegt wird. Es ist dadurch aber keine Wiederholung aller Schritte in jedem Teilexperiment notwendig, diese Abfolge muss bei der Durchführung des Verfahrens zumindest einmal auftreten. Auch können in der Evolutionsphase grundsätzlich beliebige Maßnahmen erfolgen. Diese können sich auch von Teilexperiment zu Teilexperiment unterscheiden. Bspw. hat der Phasengradient unterschiedliche Werte je nach Zeitpunkt der Messung.

Entscheidend ist, dass in der Detektionsphase wenigstens zwei Echos aufgenommen werden und nach dem ersten Echo wenigstens ein Verschiebegradient in Schichtauswahlrichtung anliegt. Dieser bewirkt eine Verschiebung der aus den Messdaten berechneten weiteren Bilder gegenüber den ersten Bildern. Es gibt immer wenigstens zwei erste Bilder, da Messsignale aus wenigstens zwei Schichten akquiriert werden. Entsprechend gibt es auch wenigstens zwei weitere Bilder.

Die Messsignale sind als Echosignale ausgebildet. FIDs wie in Spektroskopiesequenzen möglich werden nicht akquiriert.

Da die Erfindung in unterschiedlichen Messsequenzen verwendet werden kann, werden folgende Definitionen vorgenommen:
Als Messsequenz wird wie üblich eine Abfolge von HF-Impulsen, Gradientenfeldern, Wartezeiten und Akquisitionsfenstern bezeichnet, die den Ablauf der Messsequenz genau festlegen und charakterisieren. Beispiele für Messsequenzen sind die bereits angesprochenen FLASH, Spinecho, Gradientenecho, FSE, EPI, TrueFisp, etc. Diese daraus ermittelten Bilddatensätze können auch durch Präparationsmodule Wichtungen aufweisen oder zur Erstellung von Karten wie T1-Karten oder T2-Karten geeignet sein.

Eine Messsequenz besteht dabei aus definierten oder definierbaren Teilexperimenten. Ein Teilexperiment kann auch Anregungszyklus genannt werden. Bei einem Spinecho werden so viele Anregungsimpulse angelegt wie phasenkodierende Schritte durchgeführt werden. Entsprechend gibt es so viele Anregungszyklen wie phasenkodierende Schritte.

Bei einem Fast Spin Echo, werden mehrere Refokussierungsimpulse verwendet, weswegen von einem Echozug gesprochen wird.

In der vorliegenden Erfindung wird dabei zwischen einem Echozug aufgrund mehrerer Refokussierungsimpulse und einem Gradientenechozug aufgrund von Lesegradienten, insbesondere bipolaren Lesegradienten, unterschieden. Bei einem Fast Spin Echo mit 128 Phasenkodierschritten und einer Anzahl von 8 Echos in einem Echozug ergibt sich damit eine Zahl von nur 16 Anregungszyklen zur Aufnahme eines vollständigen Messdatensatzes.

Die Länge eines Anregungszyklus wird Repetitionszeit genannt und "TR" abgekürzt.

Bei einem Echozug wird die Zeit zwischen zwei Echos Interechozeit genannt und "TI" abgekürzt.

Die Echozeit wird "TE" abgekürzt.

Diese Ausführungen sollen insbesondere die bestehenden fachmännischen Konventionen darlegen.

Bei einem Spinecho weist eine erfindungsgemäße Messsequenz also wenigstens zwei Lesegradienten in einem Anregungszyklus auf, während bei einem FSE wenigstens zwei Lesegradienten in einem Echozug vorkommen. Genauer gesagt finden sich die Lesegradienten jeweils in der Detektionsphase.

Zwischen dem Anregungsimpuls und dem Refokussierungsimpuls können ein Phasenkodiergradient und/oder ein Dephasier-Lesegradient angelegt werden. Diese können aber auch einzeln oder beide nach dem Refokussierungsimpuls angelegt werden. Dies hängt manchmal von der verwendeten Messsequenz ab und manchmal von den Randbedingungen des Experimentes.

Da bei der Datenaufnahme mehrere Spulen zum Einsatz kommen wird von jeder Spule nur ein Teil eines vollständigen Satzes an k-Raum-Daten aufgenommen. Die fehlenden Daten können mit den weiter oben beschriebenen Verfahren wie GRAPPA oder SENSE berechnet werden.

Bevorzugt kann der Verschiebegradient nur in jedem n-ten Anregungszyklus und/oder jeder n-ten Detektionsphase angelegt werden, wobei n eine natürliche Zahl größer als 1 ist. Der Verschiebegradient wird also nicht in jeder Detektionsphase angelegt, sondern nur in jeder n-ten Detektionsphase. Dadurch kann die Stärke der Verschiebung beeinflusst werden.

Vorzugsweise kann der Verschiebegradient bei mehrmaligem Anlegen in unterschiedlichen und/oder gleichen Anregungszyklen das gleiche Gradientenmoment aufweisen. Auch kann der Verschiebegradient bei mehrmaligem Anlegen in unterschiedlichen Detektionsphasen das gleiche Gradientenmoment aufweisen. Ein Anregungszyklus kann bspw. im Falle eines FSE mehrere Detektionsphasen aufweisen und damit auch mehrere Verschiebegradienten, auch wenn nicht in jeder Detektionsphase der Verschiebegradient angelegt wird. Das Gradientenmoment ist gleich, wenn das das zeitliche Integral über die Gradientenamplitude gleich ist. Dabei liegt auch bei dieser Ausgestaltung der Verschiebegradient nicht zwingend in jeder Detektionsphase an. Aber wenn der Verschiebegradient anliegt, dann mit immer gleichem Gradientenmoment.

Vorteilhafterweise können die Schritte b) bis c4) in einem Anregungszyklus mehrmals durchgeführt werden. Mit anderen Worten werden die Evolutionsphase und die Detektionsphase wiederholt. Dementsprechend kann die Messsequenz als FSE ausgebildet sein.

Vorzugsweise kann die Evolutionsphase wenigstens einen, insbesondere genau einen, Refokussierungsimpuls aufweisen. Die Messsequenz ist dann als Spinecho oder FSE ausgestaltet. Der Echozug beim FSE ergibt sich dabei durch ein mehrmaliges Vorkommen der Evolutionsphase. Auch die Detektionsphase tritt dann mehrmals zu einer einzigen Anregungsphase in einem Anregungszyklus auf, wie bereits beschrieben.

Bevorzugt können als weitere Lesegradienten ein zweiter Lesegradient und ein dritter Lesegradient angelegt und ein zweites Echosignal und ein drittes Echosignal ausgelesen werden.

Vorzugsweise weist jede Detektionsphase genau drei Lesegradienten auf. Der Verschiebegradient kann dabei zwischen dem ersten und dem zweiten oder dem zweiten und dem dritten Lesegradienten bzw. Echosignal angelegt sein. Im ersten Fall sind die beiden letzten Bilddatensätze gegenüber dem ersten verschoben, im zweiten Fall nur die letzten gegenüber den ersten und zweiten Bilddatensätzen.

Vorteilhafterweise können zwei Verschiebegradienten angelegt werden, wobei einer eine Verschiebung der aus zweiten Echosignalen erzeugten zweiten Bilddatensätze gegenüber dem aus ersten Echosignalen erzeugten ersten Bilddatensätzen bewirkt und der zweite Verschiebegradient eine Verschiebung der aus dritten Echosignalen erzeugten dritten Bilddatensätzen gegenüber den aus zweiten Echosignalen erzeugten zweiten Bilddatensätzen bewirkt. Die Verwendung zweier Verschiebegradienten in einer Detektionsphase ermöglicht eine weiter verbesserte Rekonstruktion.

Die Ausführungen zum ersten Verschiebegradienten gelten grundsätzlich auch bei Verwendung zweier Verschiebegradienten. Auch diese können für sich jeweils gleiche Gradientenmomente aufweisen, nur in jedem n-ten Anregungszyklus oder jeder n-ten Detektionsphase angelegt werden, etc.

Das Gradientenmoment des zweiten Verschiebegradienten kann vorteilhafterweise ein festes Verhältnis im Vergleich zum ersten Verschiebegradienten aufweisen. Es kann insbesondere doppelt oder halb so groß sein. Weiterhin können sich die Anlegezyklen unterscheiden. So kann der erste Verschiebegradient in jeder zweiten Detektionsphase und der zweite Verschiebegradient in jeder dritten Detektionsphase angelegt werden. Gradientenmoment und/oder Anlegezyklus können aber auch jeweils identisch sein.

Das Gradientenmoment des oder der Verschiebegradienten kann insbesondere ein m-ter Teil des Gradientenmomentes des Schichtselektionsgradienten sein, wobei m eine natürliche Zahl größer als 1 ist. Das Verhältnis des Gradientenmomentes des Schichtselektionsgradienten zum Gradientenmoment des Verschiebegradienten ergibt also eine natürliche Zahl größer als 1.

Vorteilhafterweise kann der Verschiebegradient, insbesondere der erste Verschiebegradient, gleichzeitig zur End-Gradientenrampe des ersten Lesegradienten und/oder zur Anfangs-Gradientenrampe des zweiten Lesegradienten geschaltet werden. Dies ermöglicht einen Einbau in die Messsequenz, ohne das Timing in der Detektionsphase zu ändern. Dabei können eine oder zwei Gradientenrampendauern verwendet werden, die ohnehin aufgrund der Schaltung der Lesegradienten vorhanden sind. Da zu dieser Zeit die Akquisitionsfenster bereits geschlossen bzw. noch nicht offen sind wird auch die Aufnahme nicht beeinflusst.

Vorzugsweise kann der erste Verschiebegradient oder der zweite Verschiebegradient gleichzeitig zur End-Gradientenrampe des zweiten Lesegradienten und/oder zur Anfangs-Gradientenrampe des dritten Lesegradienten geschaltet werden. Bei Verwendung nur eines Verschiebegradienten kann dieser wie weiter oben bereits beschrieben vor dem zweiten Echosignal oder vor dem dritten Echosignal angelegt werden. Bei Verwendung zweier Verschiebegradienten liegen der erste Verschiebegradient vor dem zweiten Echosignal und der zweite Verschiebegradient vor dem dritten Echosignal.

Bevorzugt können die durch wenigstens einen der Verschiebegradienten beeinflussten Echosignale und das erste Echosignal die gleiche Phasenkodierung aufweisen.

Grundsätzlich können noch weitere Echosignale vorhanden sein. Bei einem 2- oder 3-Punkt-Dixon-Verfahren mit FSE sind weitere Echosignale allerdings nachteilig, da sie die Echozeit und die Interechozeit verlängern und dadurch das SNR verschlechtern. Zweite und dritte Echosignale sind dann diejenigen Echosignale, die durch den oder die Verschiebegradienten beeinflusst werden.

Grundsätzlich können die Echosignale in einem Gradientenechozug enthalten sein. Das beschrieben Vorgehen kann also in Sequenzen wie Spinecho, Fast Spin Echo, GRASE, einer Fast Spin Echo-basierten 2-Punkt-Dixon-Technik, einer Fast Spin Echo-basierten 3-Punkt-Dixon-Technik, etc. verwendet werden.

Zum Einstrahlen des Anregungsimpulses und/oder der Refokussierungsimpulse können eine Bodycoil oder ein Spulenarray verwendet werden. Das Auslesen der Gradientenechos als Echosignale erfolgt mittels eines Spulenarrays.

Vorteilhafterweise können die Schritte b) bis c4) in einem Anregungszyklus mehrmals durchgeführt werden. Es werden also mehrere Refokussierungsimpulse zur Erzeugung eines Echozuges verwendet. Die Anzahl der tatsächlich aufnehmbaren Echosignale ist dann mindestens doppelt so groß wie die Anzahl der Echos im Echozug, da immer wenigstens zwei Gradientenechos in einem Echozug erzeugt werden.

Die Schritte c) bis c4) werden insbesondere innerhalb einer Interechozeit, also zwischen zwei oder nach dem letzten Refokussierungsimpuls, vorgenommen. Mit anderen Worten werden die ersten, zweiten und dritten Echosignale einer k-Raum-Zeile in einer einzigen Detektionsphase erhalten.

Vorteilhafterweise kann bereits vor dem ersten Lesegradienten ein weiterer Verschiebegradient in Schichtauswahlrichtung angelegt sein. Dieser kann bspw. zu einem Spoilergradienten addiert oder subtrahiert werden. Er ist somit in der Evolutionsphase angelegt. Je nach der Anzahl der Verschiebegradienten in der Detektionsphase handelt es sich um den zweiten oder dritten Verschiebegradienten in Schichtauswahlrichtung. Dieser kann vom Betrag her das gleiche Gradientenmoment besitzen wie einer der anderen Verschiebegradienten. Auch ansonsten gelten die Ausführungen analog.

Bevorzugt kann in der Detektionsphase wenigstens ein Phasenverschiebegradient angelegt werden. Dabei gelten alle Ausgestaltungen bezüglich des Verschiebegradienten analog:
Vorteilhafterweise kann der Phasenverschiebegradient in unterschiedlichen Anregungszyklen und/oder Abschnitten eines Echozuges einen konstanten Sprung im k-Raum bewirken. Alternativ oder zusätzlich kann der Phasenverschiebegradient in unterschiedlichen Anregungszyklen und/oder Detektionsphasen einen unterschiedlichen Sprung im k-Raum bewirken. Dabei kann das Gradientenmoment von Anregungszyklus zu Anregungszyklus wechseln aber für alle Detektionsphasen gleich sein oder umgekehrt.

Vorteilhafterweise können Wasserprotonen und Fettprotonen während des ersten Echosignals eine entgegengesetzte Phase aufweisen. Diese Relativposition wird auch "opposed phase" oder "out of phase" genannt. Insbesondere bei der 2-Punkt-Dixon-Technik kann die Echozeit des ersten Echosignals so gewählt werden.

Bevorzugt können Wasserprotonen und Fettprotonen während eines zweiten Echosignals die gleiche Phase aufweisen.

Weiterhin können Wasserprotonen und Fettprotonen während des dritten Echosignals eine entgegengesetzte Phase aufweisen.

Vorzugsweise kann der zweite Verschiebegradient ein vom Betrag her gleiches Gradientenmoment wie der erste Verschiebegradient, aber mit entgegengesetztem Vorzeichen. D.h. dass der zweite Verschiebegradient die Wirkung des ersten Verschiebegradienten rückgängig macht.

Der Phasenverschiebegradient kann dann verwendet werden um entweder die k-Raum-Zeilen der dritten Bilddatensätze zur Ergänzung der ersten Bilddatensätze verwenden zu können oder um ein Navigatorbild zu kodieren.

Dann können mit dem ersten und zweiten Echosignal Daten für ein 2-Punkt-Dixon-Verfahren gesammelt werden und mit den dritten Echosignalen ein Navigatorbild oder Kalibrierungsdaten für die Rekonstruktion.

Werden die Navigatorechosignale als dritte Echosignale im Gradientenechozug aufgenommen und weitere Echosignale als viertes Gradientenecho, können die weiteren Echosignale "in phase" sein und den k-Raum des in-phase-Bildes, also des Bildes mit den zweiten Gradientenechos bzw. Echosignalen, ergänzen.

Bevorzugt können als Lesegradienten bipolare Gradienten verwendet werden. Diese wechseln also ihre Polarität. Dies ist üblich bei der Erzeugung eines Gradientenechozuges.

Vorteilhafterweise kann als Messsequenz ein Fast Spin Echo (FSE) verwendet werden. Bei drei Echosignalen in einem Gradientenechozug und acht Echos in einem Echozug werden in einem Anregungszyklus vierundzwanzig Echosignale akquiriert.

Vorteilhafterweise können genau drei Echosignale in einem Gradientenechozug aufgenommen werden. Bei dieser Anzahl wird die Interechozeit nur unwesentlich erhöht, aber ein großer Informationsgewinn erzielt.

Vorteilhafterweise kann nach dem dritten Lesegradienten ein weiterer Gradient in Phasenrichtung angelegt werden, der den Phasenverschiebegradienten zumindest teilweise kompensiert. Diese Gradienten werden auch Phase-Rewind-Gradienten genannt.

Vorzugsweise kann gleichzeitig zum Anregungsimpuls und/oder Refokussierungsimpuls bzw. den Refokussierungsimpulsen jeweils ein Schichtauswahlgradient anliegen. Dieser ermöglicht eine schichtselektive Anregung der Spins.

Vorzugsweise kann nach dem Auslesen des letzten Echosignals in einer Detektionsphase ein Phase-Rewind-Gradient angelegt werden. Dieser soll die Magnetisierung wieder in die Mitte des k-Raums bringen.

Die Lösung der eingangs genannten Aufgabe wird außerdem durch ein Computerprogrammprodukt bzw. ein Computerprogramm erzielt, das zur Steuerung einer Steuerungseinrichtung eingesetzt werden kann, welche eine Bilderzeugungseinheit einer Magnetresonanzanlage steuert, welches das vorgenannte erfindungsgemäße Verfahren ausführt.

Daneben betrifft die Erfindung einen Datenträger für eine Steuerungseinrichtung zur Steuerung einer Datenerzeugungseinheit einer Magnetresonanzanlage mit Daten zum Durchführen des beschriebenen Verfahrens. Vorteilhafterweise kann die Datenerzeugungseinheit eine Bilderzeugungseinheit sein.

Daneben betrifft die Erfindung eine Magnetresonanzanlage mit einer Steuerungseinrichtung. Die Magnetresonanzanlage zeichnet sich dadurch aus, dass die Steuerungseinrichtung zur Durchführung des Verfahrens wie beschrieben ausgebildet ist.

Die Implementierung der vorgenannten Verfahren in der Steuervorrichtung kann dabei als Software oder aber auch als (fest verdrahtete) Hardware erfolgen.

Weitere vorteilhafte Ausgestaltungen der erfindungsgemäßen Magnetresonanzanlage korrespondieren zu entsprechenden Ausgestaltungen des erfindungsgemäßen Verfahrens. Zur Vermeidung unnötiger Wiederholungen wird somit auf die entsprechenden Verfahrensmerkmale und deren Vorteile verwiesen.

Weitere Vorteile, Merkmale und Besonderheiten der vorliegenden Erfindung ergeben sich aus der nachfolgenden Beschreibung vorteilhafter Ausgestaltungen der Erfindung.

Dabei zeigen:
- Fig. 1: eine Magnetresonanzanlage,
- Fig. 2: eine Messsequenz in einer ersten Ausgestaltung,
- Fig. 3: ein erstes k-Raum-Abtastschema zur Messsequenz nach Figur 2,
- Fig. 4: ein zweites k-Raum-Abtastschema zur Messsequenz nach Figur 2,
- Fig. 5: ein drittes k-Raum-Abtastschema zur Messsequenz nach Figur 2,
- Fig. 6: eine Messsequenz in einer zweiten Ausgestaltung,
- Fig. 7: ein erstes k-Raum-Abtastschema zur Messsequenz nach Figur 6,
- Fig. 8: ein zweites k-Raum-Abtastschema zur Messsequenz nach Figur 6,
- Fig. 9: ein drittes k-Raum-Abtastschema zur Messsequenz nach Figur 6,
- Fig. 10: eine Messsequenz in einer dritten Ausgestaltung,
- Fig. 11: ein erstes k-Raum-Abtastschema zur Messsequenz nach Figur 10,
- Fig. 12: ein zweites k-Raum-Abtastschema zur Messsequenz nach Figur 10,
- Fig. 13: ein drittes k-Raum-Abtastschema zur Messsequenz nach Figur 10,
- Fig. 14: eine Messsequenz in einer vierten Ausgestaltung,
- Fig. 15: ein erstes k-Raum-Abtastschema zur Messsequenz nach Figur 14,
- Fig. 16: ein zweites k-Raum-Abtastschema zur Messsequenz nach Figur 14, und
- Fig. 17: ein drittes k-Raum-Abtastschema zur Messsequenz nach Figur 14.

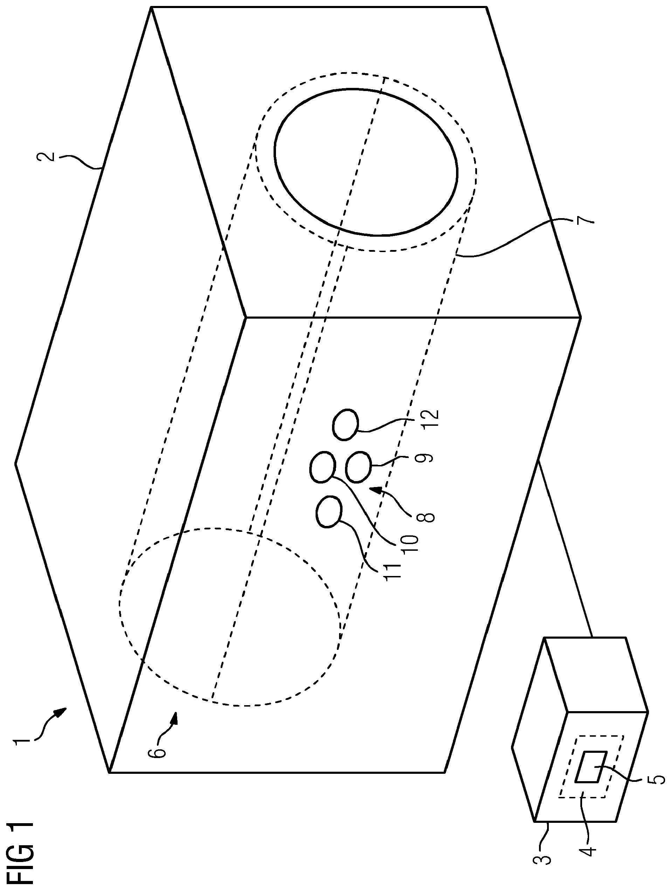

Figur 1 zeigt eine Magnetresonanzanlage 1. Diese weist als wesentliche dargestellte Komponenten ein Magnetresonanzgerät 2 und eine Steuerungseinrichtung 3 auf.

Die Steuerungsrichtung 3 umfasst einen Datenträger 4 und wenigstens ein darauf gespeichertes Computerprogrammprodukt 5. Messsequenzen können als Computerprogrammprodukte 5 ausgebildet sein.

Im Magnetresonanzgerät 2 ist eine Sendespulenanordnung 6 angeordnet. Die Sendespulenanordnung 6 ist üblicherweise als Bodycoil 7 ausgebildet. Sie besteht also aus einer einzigen Spule.

Weiterhin ist eine Empfangsspulenanordnung vorhanden. Diese ist als Spulenarray 8 mit Spulen 9, 10, 11 und 12 ausgestaltet. Zur besseren Unterscheidung ist die Sendespulenanordnung 6 gestrichelt dargestellt.

Das Spulenarray 8 wird nur zum Auslesen des Messsignals verwendet. Die Spulen 9, 10, 11 und 12 des Spulenarrays 8 akquirieren die Messsignale gleichzeitig.

Weitere Bestandteile der Magnetresonanzanlage 1 wie bspw. Gradientenspulen oder eine Patientenliege sind der Übersichtlichkeit halber nicht dargestellt.

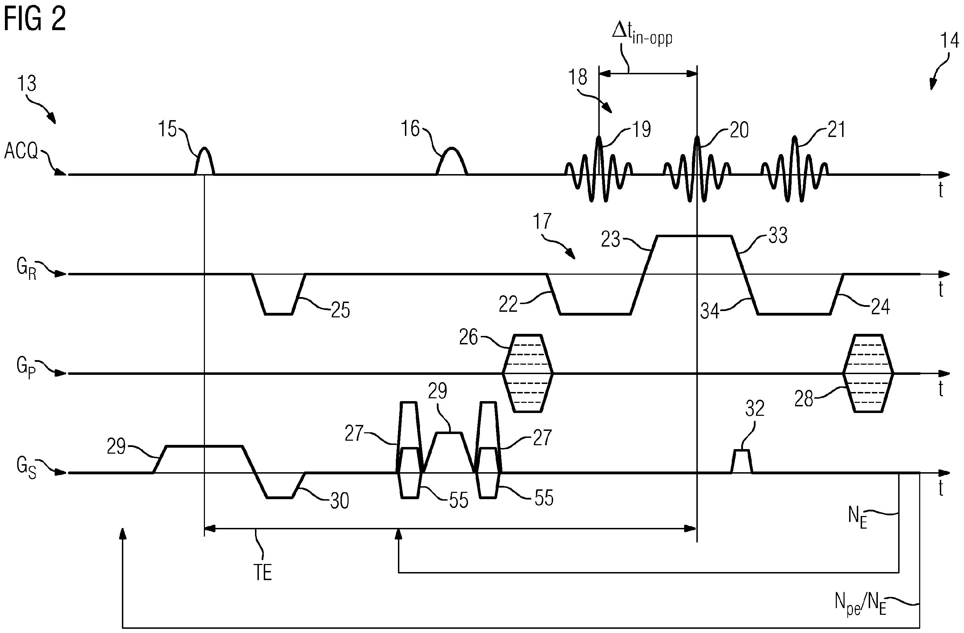

Figur 2 zeigt ein Sequenzdiagramm 13 einer FSE-Messsequenz 14 zu einer ersten Ausgestaltung der Erfindung. Mit der Messsequenz 14 können zwei Schichten gleichzeitig gemessen werden.

Hierzu ist zumindest der Anregungsimpuls 15 ein Dualbandimpuls. Der Anregungsimpuls 15 klappt die Magnetisierung um 90° aus der Longitudinalrichtung in die Transversalebene. Der Refokussierungsimpuls 16 weist dagegen einen Auslenkwinkel von 180° auf.

Der Gradientenechozug 17 erzeugt einen Echosignalzug 18 mit drei Echosignalen 19, 20 und 21. Dabei ist das mittlere Echosignal 20 gleichzeitig ein Gradientenecho und ein Spinecho, wie bei spinechobasierten Sequenzen üblich. Dieses wird durch die Abfolge von Anregungsimpuls 15 und Refokussierungsimpuls 16 oder Refokussierungsimpulsen 16 erzeugt. Wie viele Refokussierungsimpulse 16 einem Spinecho vorangehen hängt dabei davon ab, welchen Echosignalzug des Echozugs eines FSE man betrachtet.

Dabei ist das mittlere Echosignal 20 dasjenige, dessen Mitte die Echozeit TE definiert.

Δtᵢₙ₋ₒₚₚ bezeichnet den Zeitabstand zwischen einer "in phase"- und einer "opposed phase"-Anordnung der Wasser- und Fettprotonen

Jedes der Echosignale 19, 20 und 21 weist Signale aus zwei Schichten auf. Dabei könne auch mehr Schichten gleichzeitig akquiriert werden, der Anregungsimpuls 15 muss eine entsprechende Anzahl an Bändern aufweisen.

Die Lesegradienten 22, 23 und 24 des Gradientenzugs 17 sind dabei so gelegt, dass beim Echosignal 19 Wasserprotonen und Fettprotonen aus dem Untersuchungsbereich gegenphasig angeordnet sind, beim Echosignal 20 in Phase und beim Echosignal 21 wieder gegenphasig.

Die Echosignale 19 und 20 können daher verwendet werden, um ein 2-Punkt-Dixon-Verfahren durchzuführen. Aus den Echosignalen 19 und 20 können also separate Wasser- und Fettbilder berechnet werden.

Die Echosignale 19, 20 und 21 werden mit dem Spulenarray 8 akquiriert. Dadurch können auch die mit dem als Dualbandimpuls ausgebildeten Anregungsimpuls 15 angeregten Schichten entfaltet werden. Das beschriebene Verfahren ist somit ein Verfahren zur parallelen Bildgebung. Im Unterschied zur Bildgebung mit einer einzigen Detektionsspule werden dann weniger Phasenkodierschritte verwendet. Die Phasenkodierschritte sind im Sequenzdiagramm13 mit Nₚₑ abgekürzt. Nₚₑ steht dabei für "number of phase encoding steps". N_{E} bezeichnet die Anzahl der Echos des Echozuges der Messsequenz 14. Die Anzahl der Anregungszyklen ergibt sich daher zu Nₚₑ/N_{E}.

Neben den Lesegradienten 22, 23 und 24 weist die Messsequenz 14 in Leserichtung G_{R} außerdem einen Lese-Dephasiergradienten 25 auf. Dessen Moment ist üblicherweise halb so groß wie das durch einen der Lesegradienten 22, 23 oder 24 erzeugte Moment.

Die Lesegradienten 22, 23 und 24 sind bipolar, ihre Polarität wechselt ab.

In Phasenrichtung G_{P} liegen ein Phasenkodiergradient 26 und ein Phase-Rewind-Gradient 28 an. Der Phase-Rewind-Gradient 28 kompensiert dabei den Phasenkodiergradienten 26, sodass die Gesamtphase in Phasenrichtung zwischen zwei Anregungsimpulsen 15 gleich Null ist. Dies ist von FSE-Messsequenzen bekannt.

In Schichtrichtung G_{S} findet sich neben den Schichtauswahlgradienten 29 und 30 und dem Schicht-Rephasiergradienten 31 auch ein Verschiebegradient 32.

Zusätzlich ist der Refokussierungsimpuls 15 von Spoilergradienten 27 umgeben.

Der Verschiebegradient 32 ist nach dem zweiten Echosignal 20 angeordnet. Er ist genauer gesagt gleichzeitig zur End-Gradientenrampe 33 des zweiten Lesegradienten 23 und zur Anfangs-Gradientenrampe 34 des dritten Lesegradienten 24 angeordnet. Dadurch kann der Verschiebegradient 32 in die Messsequenz 14 eingebaut werden, ohne die Zeitpunkte der Echosignale 19, 20 und 21 zu verschieben.

Der Verschiebegradient 32 bewirkt an dieser Stelle eine Verschiebung der Bilder, die aus den Echosignalen 21 ermittelt werden, gegenüber den Bildern, die aus den Echosignalen 19 und 20 berechnet werden.

Der Verschiebegradient 32 wird dabei nicht in jeder Detektionsphase 35 angelegt, sondern nur in jeder zweiten.

Der Verschiebegradient 32 folgt auf Gradienten 55 in Schichtauswahlrichtung G_{S}. Die Gradienten 55 sind blipped CAIPIRINHA-Gradienten und dienen zur besseren Entfaltung bei Multislice-Experimenten bei paralleler Bildgebung. Ein Gradient 55 hat vom Betrag her in den meisten Fällen das gleiche Moment wie der Verschiebegradient 32, und entweder die gleiche oder eine entgegengesetzte Polarität. Vom Betrag her muss der Gradient 55 nicht zwingend gleich groß sein wie der Verschiebegradient 32, das ist z.B. dann der Fall, wenn FOV-Shift-Faktoren ungleich 2 verwendet werden sollen. Die Gradienten 55 sind jeweils in positiver und negativer Richtung angeordnet und gleichzeitig zu den Spoilergradienten 27 angelegt. In der Praxis wird das Gradientenmoment des Gradienten 55 zu der des Spoilergradienten 27 addiert oder subtrahiert und ein einziger Gradient angelegt.

Wird der Verschiebegradient 32 angelegt, kann entweder der erste oder der zweite Gradient 55 entfallen. Der angelegte Gradient 55 kann wie der Verschiebegradient angelegt werden, also nur in jedem zweiten Anregungszyklus, ...

Durch das Zusammenspiel des Gradienten 55 und des Verschiebegradienten 32 ergibt sich das in den folgenden Figuren gezeigte Abtastschema.

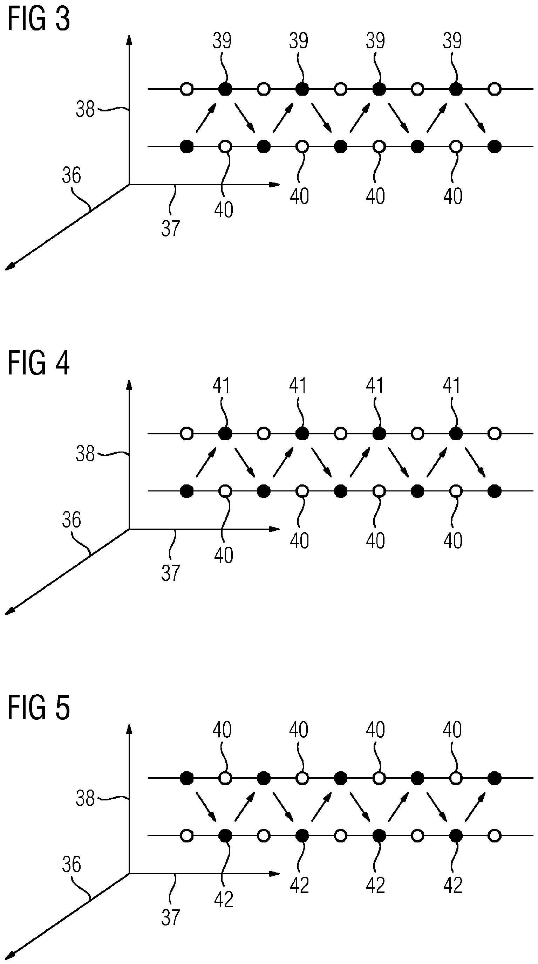

Die Figuren 3 bis 5 zeigen die Abtastung der k-Räume zu den Echosignalen 19, 20 und 21. Bei allen derartigen folgenden Figuren sind die akquirierten k-Raum-Zeilen schwarz gefüllt und die ausgelassenen k-Raum-Zeilen weiß gefüllt dargestellt.

Figur 3 zeigt die Abtastung des k-Raums für das Echosignal 19. Wie auch in den folgenden Figuren zeigt die Achse 36 die kₓ-Richtung, die Achse 37 die ky-Richtung und die Achse 38 die k_{z}-Richtung. Die akquirierten k-Raum-Zeilen 39 sind dabei im Querschnitt kreisförmig dargestellt, da sie in der gewählten Darstellung sozusagen in das Blatt hineingehen. Die weiß gefüllten Kreise 40 zeigen dagegen ausgelassene k-Raum-Zeilen an.

In Figur 4 sind die akquirierten k-Raum-Zeilen 41 des Echosignals 20 dargestellt. Diese sind identisch zu Figur 3 angeordnet.

Die aufgenommenen k-Raum-Zeilen 42 des Echosignals 21 in Figur 5 sind dagegen in z-Richtung verschoben. Dies wird durch den Verschiebegradienten bewirkt, da die restliche Signalkodierung gleich bleibt.

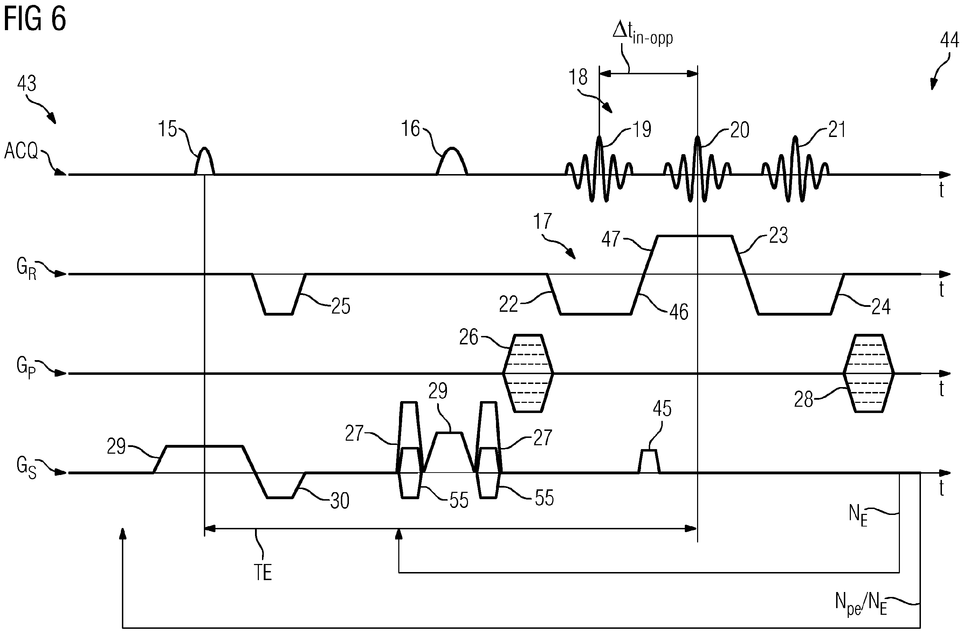

Figur 6 zeigt ein Sequenzdiagramm 43 einer Messsequenz 44. Die Messsequenz ist weitgehend identisch zu der Messsequenz 14 in Figur 2. Dabei gelten die Ausführungen zu gleichen Elementen ebenso für diese Elemente in Figur 6.

Der einzige Unterschied zu Figur 2 besteht darin, dass der Verschiebegradient 45 bereits direkt nach dem ersten Echosignal 19 angelegt wird und damit gleichzeitig zu der End-Gradientenrampe 46 des ersten Lesegradienten 22 und der Anfangs-Gradientenrampe 47 des zweiten Lesegradienten 23 anliegt.

Der Verschiebegradient 45 wirkt so auf die beiden Echosignale 20 und 21.

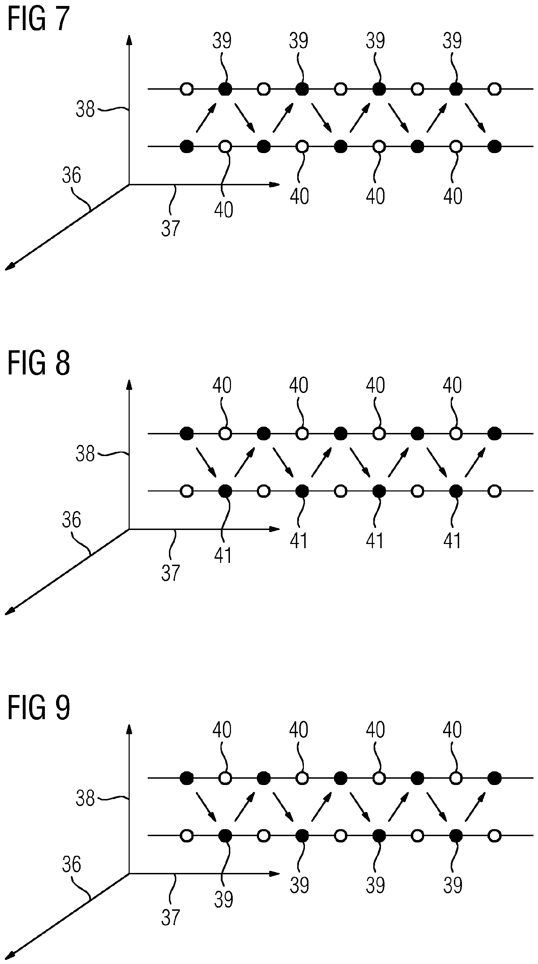

Die Figuren 7 bis 9 zeigen die Abtastung der k-Räume zu den Echosignalen 19, 20 und 21 zu der Messsequenz 44 in Figur 6.

Dabei ist die Figur 7 identisch zu Figur 3, da sich die Kodierung bezüglich des Echosignals 19 nicht geändert hat.

Figur 8 zeigt dagegen einen Unterschied zu Figur 4, die sich beide auf das Echosignal 20 beziehen. In Figur 8 erfolgt die Abtastung wie in Figur 5. Dies ergibt sich daraus, dass der Verschiebegradient 45 sowohl das Echosignal 20 wie auch das Echosignal 21 beeinflusst.

Dementsprechend sind auch die Figuren 5 und 9 identisch, da der Verschiebegradient 32 bzw. 45 sowohl in der Messsequenz 14 als auch in der Messsequenz 44 auf das Echosignal 21 wirkt.

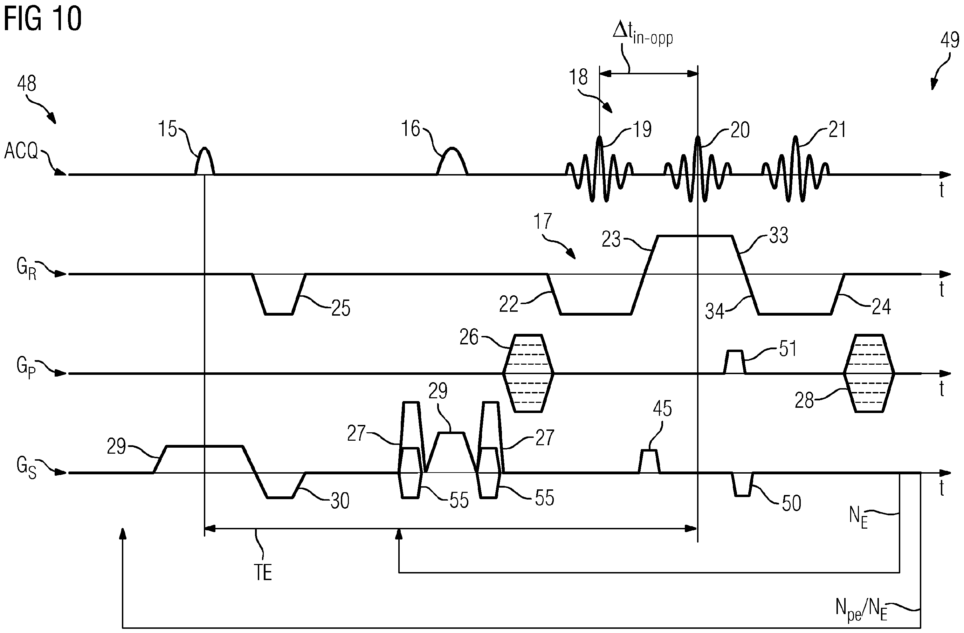

Figur 10 zeigt ein Sequenzdiagramm 48 einer Messsequenz 49. Die Messsequenz 49 unterscheidet sich von den Messsequenzen 14 und 44 dahingehend, dass zwei Verschiebegradienten 45 und 50 verwendet werden. In der Ausgestaltung nach Figur 10 hebt der Verschiebegradient 50 die Wirkung des Verschiebegradienten 45 für das Echosignal 21 auf. Der Verschiebegradient 50 kann alternativ aber auch so gewählt werden, dass er eine weitere Verschiebung des Echosignals 21 und zwar sowohl gegenüber dem Echosignal 19 als auch dem Echosignal 20 bewirkt. Die Verschiebegradienten 45 und 50 weisen beim Anlegen über alle Detektionsphasen das gleiche Gradientenmoment auf.

Zusätzlich ist als weitere optionale Ausgestaltung ein Phasenverschiebegradient 51 vorhanden. Dieser ist so ausgestaltet, dass er den k-Raum in ky-Richtung um eine Zeile verschiebt.

Somit wirkt in der Ausgestaltung nach Figur 10 der Verschiebegradient 45 effektiv nur auf das Echosignal 20. Auch der Phasenverschiebegradient 51 wirkt in der ersten Detektionsphase nur auf das Echosignal 21.

Der Phase-Rewind-Gradient 28 ist vom Gradientenmoment dann so angepasst, dass sich insgesamt in Phasenrichtung wieder ein Gradientenmoment von Null ergibt.

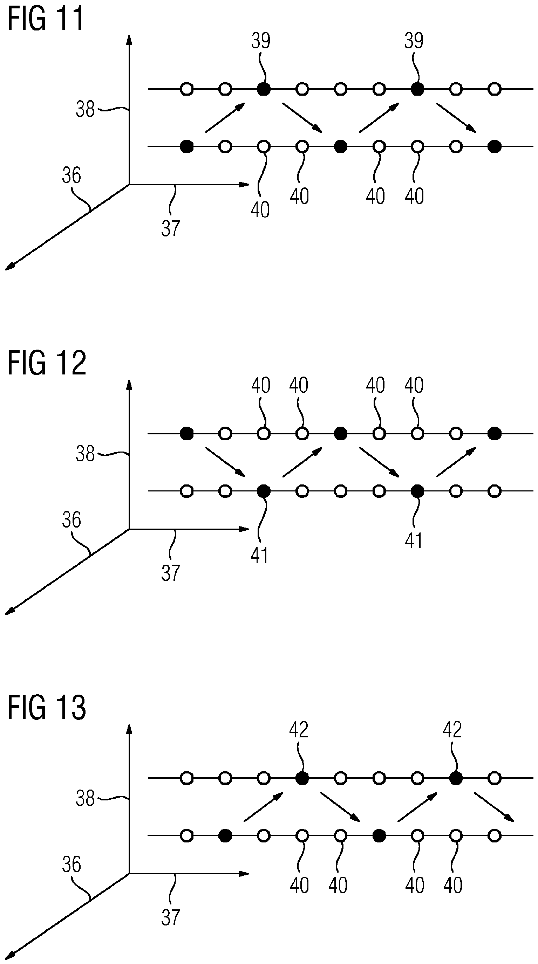

Die Figuren 11 bis 13 zeigen die Abtastung der k-Räume zu den Echosignalen 19, 20 und 21 zu der Messsequenz 49 in Figur 10.

Während sich in Figur 11 und 12 der Verschiebegradient 51 nicht bemerkbar macht ist in Figur 13 die erste ky-Zeile ausgelassen. Dies ergibt sich aufgrund des Verschiebegradienten 51.

Der Verschiebegradient 45 zeigt dagegen nur in Figur 12 Auswirkungen, da wie beschrieben seine Wirkung für das Echosignal 21, das in Figur 13 gezeigt ist, durch den Verschiebegradienten 50 aufgehoben wird.

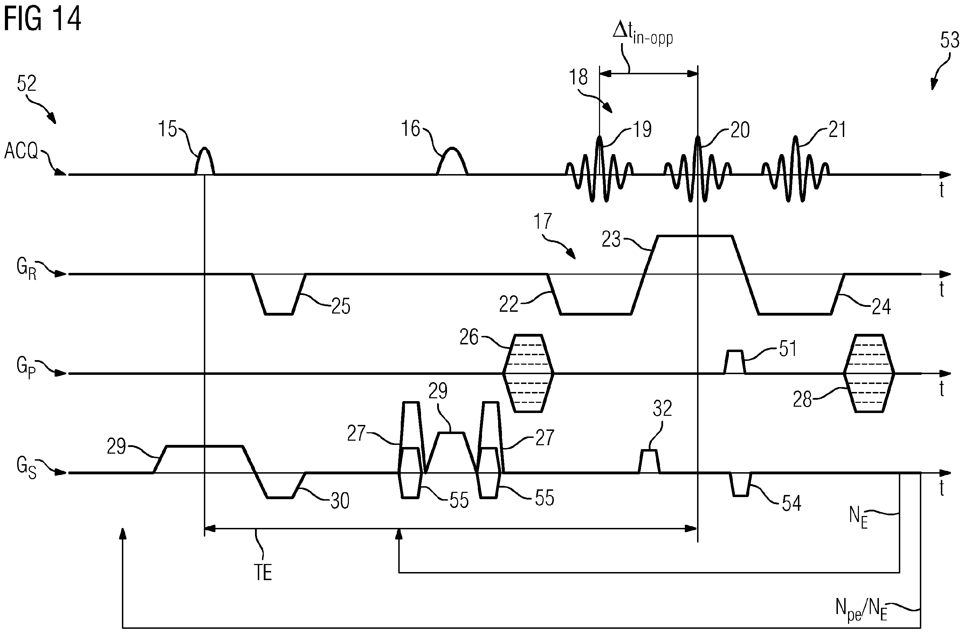

Figur 14 zeigt ein Sequenzdiagramm 52 einer Messsequenz 53. Diese weist im Wesentlichen die gleichen Bestandteile auf wie die Messsequenzen 14, 44 und 49. Im Unterschied zu Messsequenz 49 ist der zweite Verschiebegradient 54 in Schichtrichtung G_{S} variabel. Ebenso ist grundsätzlich der Verschiebegradient 51 variabel verwendbar. D.h. dass er in unterschiedlichen Detektionsphasen unterschiedliche Gradientenmomente aufweisen kann.

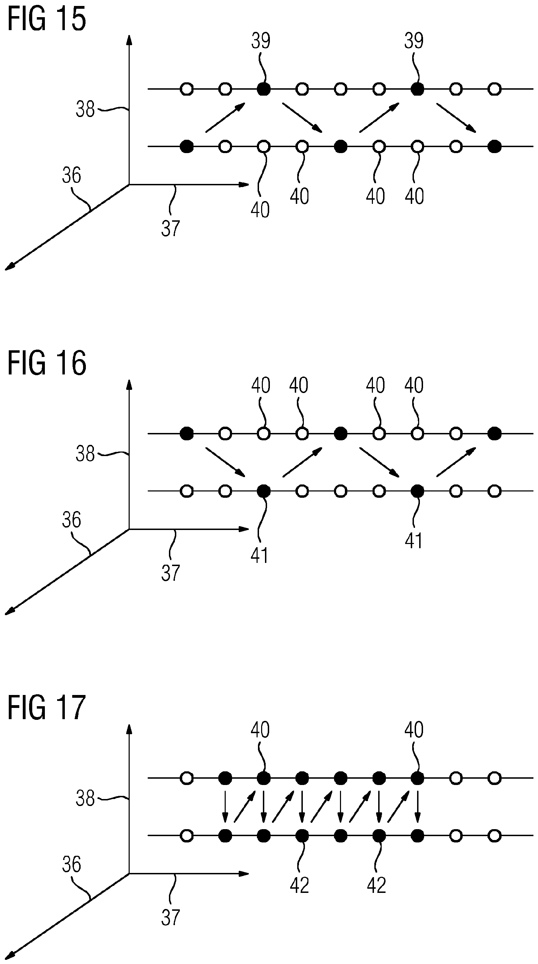

Somit ergeben sich zu Messsequenz 53 die in den Figuren 15 bis 17 gezeigten Abtastungen. Die Abtastung des Echosignals 19 in Figur 15 entspricht der von Figur 11. Die Abtastung des Echosignals 20 in Figur 16 entspricht der von Figur 12.

Die Abtastung des Echosignals 21 verläuft aber unterschiedlich zu den bisherigen Abtastungen. Es kann sich beispielsweise eine Abtastung wie in Figur 17 gezeigt ergeben. Dabei können sich die Echosignale 19 und 21 so ergänzen, dass ein kompletter k-Raum abgetastet wird. Diese ergänzenden Daten können bspw. als Kalibrierungsdaten für eine GRAPPA-Rekonstruktion verwendet werden.

Die Messsequenzen 14, 44, 49 und 53 zeigen alle eine FSE-Sequenz mit Gradientenechozug 17, wobei die ersten und dritten Echosignale 19 bzw. 21 opposed phase und die zweiten Echosignale 20 in phase aufgenommen werden. Als Anregungsimpuls wird, unabhängig vom Gradientenechozug, ein Dualbandpuls verwendet, um zwei Messschichten gleichzeitig aufzunehmen.

Die Anwendung der Verschiebegradienten 32, 45, 50, 51 und 54 kann aber auch bei anderen Sequenzen, die wenigstens einen Gradientenechozug mit zwei Echos besitzen, angewendet werden.

## Patentansprüche

1. Verfahren zur Aufnahme eines Magnetresonanzdatensatzes mit mehreren Spulen (9, 10, 11, 12), wobei die Messsignale (19, 20, 21) des Magnetresonanzdatensatzes Messsignale wenigstens zweier Bilddatensätze jeweils aus wenigstens zwei Schichten enthalten, mit den Schritten:
a) Anregungsphase,
b) Evolutionsphase,
c) Detektionsphase (35) mit den Schritten:
c1) Auslesen eines ersten Echosignals (19) während ein erster Lesegradient (22) anliegt,
c2) Anlegen wenigstens eines Verschiebegradienten (32, 45, 50, 54) in Schichtauswahlrichtung, und
c3) Auslesen wenigstens eines weiteren Echosignals (21, 22) während ein weiterer Lesegradient (23, 24) anliegt, wobei
c4) der Verschiebegradient (32, 45, 50, 54) so positioniert ist, dass er eine Verschiebung wenigstens eines aus dem oder den weiteren Echosignalen (20, 21) erzeugten weiteren Bilddatensatzes gegenüber dem aus ersten Echosignalen (19) erzeugten ersten Bilddatensatz bewirkt.

2. Verfahren nach Anspruch 1, **dadurch gekennzeichnet, dass** der Verschiebegradient (32, 45, 50, 54) nur jeden n-ten Anregungszyklus und/oder in jeder n-ten Detektionsphase angelegt wird, wobei n eine natürliche Zahl größer als 1 ist.

3. Verfahren nach Anspruch 1 oder 2, **dadurch gekennzeichnet, dass** der Verschiebegradient (32, 45, 50, 54) bei mehrmaligem Anlegen in unterschiedlichen und/oder gleichen Anregungszyklen das gleiche Gradientenmoment aufweist.

4. Verfahren nach einem der vorangehenden Ansprüche, **dadurch gekennzeichnet, dass** die Schritte b) bis c4) in einem Anregungszyklus mehrmals durchgeführt werden.

5. Verfahren nach einem der vorangehenden Ansprüche, **dadurch gekennzeichnet, dass** als weitere Lesegradienten (23, 24) ein zweiter Lesegradient (23) und ein dritter Lesegradient (24) angelegt und ein zweites Echosignal (20) und ein drittes Echosignal (21) ausgelesen werden.

6. Verfahren nach Anspruch 5, **dadurch gekennzeichnet, dass** zwei Verschiebegradienten (45, 50, 54) angelegt werden, wobei der erste Verschiebegradient (45) eine Verschiebung des aus zweiten Echosignalen (20) erzeugten zweiten Bilddatensatzes gegenüber dem aus ersten Echosignalen (19) erzeugten ersten Bilddatensatz bewirkt und der zweite Verschiebegradient (50, 54) eine Verschiebung des aus dritten Echosignalen (21) erzeugten dritten Bilddatensatzes gegenüber dem aus zweiten Echosignalen (20) erzeugten zweiten Bilddatensatz bewirkt.

7. Verfahren nach einem der vorhergehenden Ansprüche, **dadurch gekennzeichnet, dass** der Verschiebegradient (32, 45, 50, 54), insbesondere der erste Verschiebegradient (45), gleichzeitig zur End-Gradientenrampe (46) des ersten Lesegradienten (22) und/oder zur Anfangs-Gradientenrampe (47) des zweiten Lesegradienten (23) geschaltet wird.

8. Verfahren nach einem der vorhergehenden Ansprüche, **dadurch gekennzeichnet, dass** der Verschiebegradient (32, 50, 54), insbesondere der zweite Verschiebegradient (50, 54) gleichzeitig zur End-Gradientenrampe (33) des zweiten Lesegradienten (23) und/oder zur Anfangs-Gradientenrampe (34) des dritten Lesegradienten (24) geschaltet wird.

9. Verfahren nach einem der vorhergehenden Ansprüche, **dadurch gekennzeichnet, dass** Wasserprotonen und Fettprotonen während des Auslesens der Echosignale (19, 20, 21) gleichsinnige und/oder entgegengesetzte Phasen aufweisen.

10. Verfahren nach einem der vorhergehenden Ansprüche, **dadurch gekennzeichnet, dass** als Lesegradienten (22, 23, 24) bipolare Gradienten verwendet werden.

11. Verfahren nach einem der vorhergehenden Ansprüche, **dadurch gekennzeichnet, dass** als Messsequenz (14, 44, 49, 53) ein Fast Spin Echo (FSE) verwendet wird.

12. Verfahren nach einem der vorhergehenden Ansprüche, **dadurch gekennzeichnet, dass** genau drei Echosignale (19, 20, 21) in einem Gradientenechozug (18) aufgenommen werden.

13. Computerprogrammprodukt (5) für eine Steuerungseinrichtung (3) zur Steuerung einer Datenerzeugungseinheit, insbesondere einer Bilderzeugungseinheit, einer Magnetresonanzanlage (1) zum Durchführen eines Verfahrens gemäß einem der vorhergehenden Ansprüche.

14. Datenträger (4) für eine Steuerungseinrichtung (3) zur Steuerung einer Datenerzeugungseinheit, insbesondere Bilderzeugungseinheit, einer Magnetresonanzanlage (1) mit Daten zum Durchführen eines Verfahrens gemäß einem der vorhergehenden Ansprüche.

15. Magnetresonanzanlage (1) mit einer Steuerungseinrichtung (3), **dadurch gekennzeichnet, dass** die Steuerungseinrichtung (3) zur Durchführung eines Verfahrens nach einem der Ansprüche 1 bis 12 ausgebildet ist.

## Geänderte Patentansprüche

### Geänderte Patentansprüche gemäss Regel 137(2) EPÜ.

1. Verfahren zur Aufnahme eines Magnetresonanzdatensatzes mit mehreren Spulen (9, 10, 11, 12), wobei die Messsignale (19, 20, 21) des Magnetresonanzdatensatzes Messsignale wenigstens zweier Bilddatensätze jeweils aus wenigstens zwei Schichten enthalten, mit den Schritten:
a) Anregungsphase,
b) Evolutionsphase,
c) Detektionsphase (35) mit den Schritten:
c1) Auslesen eines ersten Echosignals (19) eines ersten Bilddatensatzes während ein erster Lesegradient (22) anliegt,
c2) Anlegen wenigstens eines Verschiebegradienten (32, 45, 50, 54) in Schichtauswahlrichtung, und
c3) Auslesen wenigstens eines weiteren Echosignals (21, 22) eines weiteren Bilddatensatzes während ein weiterer Lesegradient (23, 24) anliegt, wobei
c4) der Verschiebegradient (32, 45, 50, 54) so positioniert ist, dass er eine Verschiebung wenigstens eines aus dem oder den weiteren Echosignalen (20, 21) erzeugten weiteren Bilddatensatzes gegenüber dem aus ersten Echosignalen (19) erzeugten ersten Bilddatensatz bewirkt.

2. Verfahren nach Anspruch 1, **dadurch gekennzeichnet, dass** der Verschiebegradient (32, 45, 50, 54) nur in jeder n-ten Detektionsphase angelegt wird, wobei n eine natürliche Zahl größer als 1 ist.

3. Verfahren nach Anspruch 1 oder 2, **dadurch gekennzeichnet, dass** der Verschiebegradient (32, 45, 50, 54) bei mehrmaligem Anlegen in unterschiedlichen und/oder gleichen Anregungszyklen das gleiche Gradientenmoment aufweist.

4. Verfahren nach einem der vorangehenden Ansprüche, **dadurch gekennzeichnet, dass** die Schritte b) bis c4) in einem Anregungszyklus mehrmals durchgeführt werden.

5. Verfahren nach einem der vorangehenden Ansprüche, **dadurch gekennzeichnet, dass** als weitere Lesegradienten (23, 24) ein zweiter Lesegradient (23) und ein dritter Lesegradient (24) angelegt und ein zweites Echosignal (20) und ein drittes Echosignal (21) ausgelesen werden.

6. Verfahren nach Anspruch 5, **dadurch gekennzeichnet, dass** zwei Verschiebegradienten (45, 50, 54) angelegt werden, wobei der erste Verschiebegradient (45) eine Verschiebung des aus zweiten Echosignalen (20) erzeugten zweiten Bilddatensatzes gegenüber dem aus ersten Echosignalen (19) erzeugten ersten Bilddatensatz bewirkt und der zweite Verschiebegradient (50, 54) eine Verschiebung des aus dritten Echosignalen (21) erzeugten dritten Bilddatensatzes gegenüber dem aus zweiten Echosignalen (20) erzeugten zweiten Bilddatensatz bewirkt.

7. Verfahren nach einem der vorhergehenden Ansprüche, **dadurch gekennzeichnet, dass** der Verschiebegradient (32, 45, 50, 54), insbesondere der erste Verschiebegradient (45), gleichzeitig zur End-Gradientenrampe (46) des ersten Lesegradienten (22) und/oder zur Anfangs-Gradientenrampe (47) des zweiten Lesegradienten (23) geschaltet wird.

8. Verfahren nach einem der vorhergehenden Ansprüche, **dadurch gekennzeichnet, dass** der Verschiebegradient (32, 50, 54), insbesondere der zweite Verschiebegradient (50, 54) gleichzeitig zur End-Gradientenrampe (33) des zweiten Lesegradienten (23) und/oder zur Anfangs-Gradientenrampe (34) des dritten Lesegradienten (24) geschaltet wird.

9. Verfahren nach einem der vorhergehenden Ansprüche, **dadurch gekennzeichnet, dass** Wasserprotonen und Fettprotonen während des Auslesens der Echosignale (19, 20, 21) in Phase sind und/oder entgegengesetzte Phasen aufweisen.

10. Verfahren nach einem der vorhergehenden Ansprüche, **dadurch gekennzeichnet, dass** als Lesegradienten (22, 23, 24) bipolare Gradienten verwendet werden.

11. Verfahren nach einem der vorhergehenden Ansprüche, **dadurch gekennzeichnet, dass** als Messsequenz (14, 44, 49, 53) ein Fast Spin Echo (FSE) verwendet wird.

12. Verfahren nach einem der vorhergehenden Ansprüche, **dadurch gekennzeichnet, dass** genau drei Echosignale (19, 20, 21) in einem Gradientenechozug (18) aufgenommen werden.

13. Computerprogrammprodukt (5) für eine Steuerungseinrichtung (3) zur Steuerung einer Datenerzeugungseinheit, insbesondere einer Bilderzeugungseinheit, einer Magnetresonanzanlage (1) zum Durchführen eines Verfahrens gemäß einem der vorhergehenden Ansprüche.

14. Datenträger (4) für eine Steuerungseinrichtung (3) zur Steuerung einer Datenerzeugungseinheit, insbesondere Bilderzeugungseinheit, einer Magnetresonanzanlage (1) mit Daten zum Durchführen eines Verfahrens gemäß einem der vorhergehenden Ansprüche.

15. Magnetresonanzanlage (1) mit einer Steuerungseinrichtung (3), **dadurch gekennzeichnet, dass** die Steuerungseinrichtung (3) zur Durchführung eines Verfahrens nach einem der Ansprüche 1 bis 12 ausgebildet ist.
